# EUROPEAN PATENT SPECIFICATION

(11) **EP 2 161 790 B1**
(45) Date of publication and mention of the grant of the patent: **23.01.2013**
(21) Application number: 08765584.1
(22) Date of filing: 13.06.2008
(51) Int. Cl.: H01R 13/52, H05K 5/06, H02G 3/08

(54) **WATERPROOF CONNECTOR, MOUNTING STRUCTURE FOR WATERPROOF CONNECTOR, AND MOUNTING METHOD FOR WATERPROOF CONNECTOR**
WASSERDICHTER STECKER, MONTAGESTRUKTUR FÜR WASSERDICHTEN STECKER UND MONTAGEVERFAHREN FÜR WASSERDICHTEN STECKER
CONNECTEUR ETANCHE A L'EAU, STRUCTURE ET PROCEDE DE MONTAGE DESTINES A UN TEL CONNECTEUR

(30) Priority: 28.06.2007 JP 2007170745
(43) Date of publication of application: 10.03.2010
(73) Proprietor: Tyco Electronics Japan G.K., Takatsu-ku Kawasaki-shi Kanagawa 213-8535 (JP); Toyota Jidosha Kabushiki Kaisha, Toyota-shi, Aichi 471-8571 (JP)
(72) Inventor: HOMME, Hidetaka, Kawasaki-shi Kanagawa 213-8535 (JP); ASAKURA, Ken, Toyota-shi Aichi 471-8571 (JP); IWATA, Shuichi, Toyota-shi Aichi 471-8571 (JP)
(74) Representative: Johnstone, Douglas Ian
(86) International application number: PCT/JP2008/060874
(87) International publication number: WO 2009/001694

(56) References cited:
- EP-A2- 0 893 852
- DE-A1- 3 728 456
- JP-A- 10 340 755
- JP-A- 11 121 102
- JP-A- 2007 127 206
- JP-U- 04 020 268
- US-A- 6 113 424
- US-A- 6 132 230

## Description

### Technical Field

The present invention relates to a waterproof connector, and, more particularly, to a mounting structure of the waterproof connector and a mounting method of the waterproof connector.

### Background Art

Among electronic devices connected to external circuits through connectors, some are required to be waterproofed. For example, an automotive electronic control unit is required to have high airtightness since there is a case in which the electronic control unit is mounted at a location where it is wet with water and the like or where the temperature greatly varies. For this type of electronic device required to be airtight, there is widely adopted a structure in which a sealing member is disposed between a case that contains an electronic circuit and a connector.

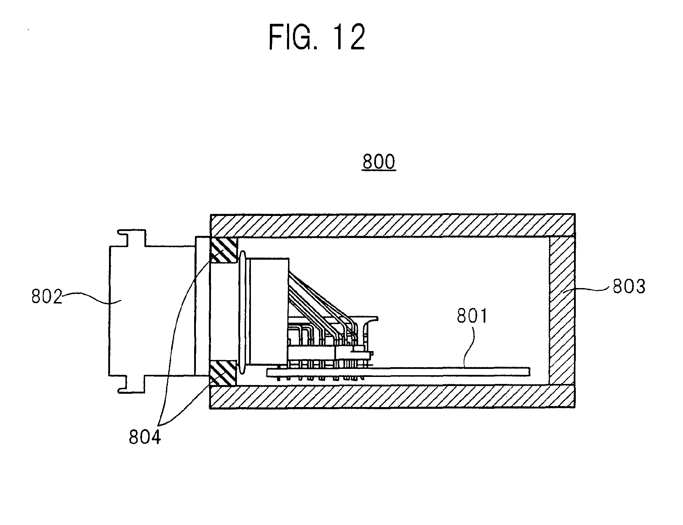

FIG. 12 is a cross-sectional diagram that schematically shows an example of the internal structure of a conventional electronic device.

An electronic device 800 shown in FIG. 12 includes: a case 803; a connector 802 fixed to the case 803 with an adhesive resin 804; and a circuit board 801 fixed to the connector 802. Incidentally, illustration of components mounted on the circuit board 801 except the connector 802 is omitted. Also, illustration of an adhesive resin, which fills a space between the bottom surface of the case 803 and the undersurface of the circuit board 801 so as to improve its resistance to vibration and heat radiation property, is omitted. The electronic device 800 is assembled in such a manner that at first the connector 802 is fixed to and integrated with the circuit board 801 and subsequently, the connector 802 integrated with the circuit board 801 is installed in and secured to the case 803. When the circuit board 801 is installed in the case 803, the edge of an opening portion of the case 803 is located at a groove formed on the circumference of the connector 802. The groove of the connector 802 is filled with an adhesive resin 804, thereby sealing a gap between the connector 802 and the case 803. In this assembly, the case 803, the connector 802 and the circuit board 801 are integrated.

The electronic device 800 with the structure shown in FIG. 12 has such a problem that if an attempt is made to increase the number of components to be mounted on the circuit board 801, or increase the sizes of these components, or incorporate two or more circuit boards, the connector 802 would not be able to support the circuit board 801. For example, solder may be cracked because of an excessive load applied to a solder joint. Therefore, in order to allow an increase in the number or sizes of components, or mounting of two or more circuit boards, it is necessary to directly install the circuit board in the case. When the circuit board is directly installed in the case, the position of the circuit board with respect to the case is deviated from a reference position in design within installation tolerance. Further, the position of the connector with respect to the circuit board also is displaced within installation tolerance. The displacements of these positions finally appear as a displacement of the position of the connector with respect to the case. In particular, when a displacement of the position of the circuit board with respect to the case and a displacement of the position of the connector with respect to the circuit board take place in the same direction, the displacements are accumulated, resulting in a large displacement.

However, the structure of the electronic device 800 shown in FIG. 12 hardly allows a positional displacement between the connector 802 and the case 803. This is because if the displacement of the position is increased by accumulation, there is a possibility that the connector 802 cannot be installed in the case 803. Also, even if the opening portion of the case 803 is made larger, there is a possibility that the gap between the case 803 and the connector 802 cannot be filled with the adhesive resin 804.

Therefore, there is proposed a structure in which two or more connectors are used to improve the degree of flexibility in terms of layout in the case.

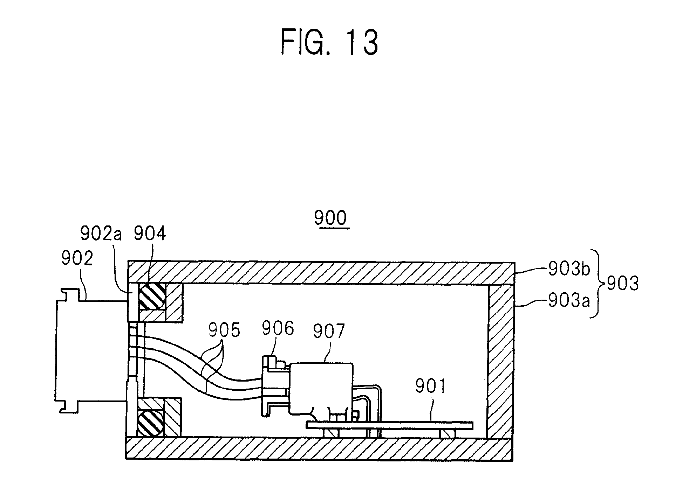

FIG. 13 is a cross-sectional diagram that schematically shows another example of the internal structure of a conventional electronic device.

In an electronic device 900 shown in FIG. 13, a circuit board 901 is fixed to a case 903 composed of a case main body 903a and a case cover 903b. An internal connector 907 is fixed to the circuit board 901. An external connector 902 to be connected to a mating connector (not illustrated) has a flange 902a abutted on an opening portion of the case 903. A gap between an abutting surface of the flange 902a of the external connector 902 and the case 903 is sealed by an elastomeric sealing member 904. The external connector 902 is connected to a relay connector 906 via internal wires 905. The relay connector 906 is connected to the internal connector 907 fixed to the circuit board 901. In the electronic device 900, because the gap between the flange 902a of the external connector 902 and the case 903 is sealed by the sealing member 904, it is possible to make the opening portion of the case 903 larger and also to set a less strict tolerance for the installation position of the external connector 902 as compared to that in the structure shown in FIG. 12. Further, according to the electronic device 900, the position of the external connector 902 with respect to the case 903 is not affected by a displacement in installation position between the circuit board 901 and the case 903 and a displacement in installation position between the internal connector 907 and the circuit board 901.

[Patent Citation 1] Japanese Patent Laid-Open No. H10-21988.

DE 37 28 456 A1 describes a waterproof connector assembly serving as basis for the preamble of claim 1. US 6 132 230 A describes another waterproof connector assembly.

### Disclosure of Invention

The electronic device 900 shown in FIG. 13 can improve the degree of flexibility in layout thanks to the structure using the internal wires. On the other hand however, the electronic device 900 requires the internal connector 907, the relay connector 906 and the internal wires 905 besides the external connector 902, thereby increasing the number of components. Also, connection work and the like within the case 903 are necessary.

In view of the foregoing, it is an object of the present invention to provide a mounting structure of a waterproof connector that is easily and reliably assembled. Another object is to provide a mounting method for the waterproof connector.

The present invention consists in a mounting structure of a waterproof connector as set forth in claim 1 hereof.

With the present invention, the cover member is fitted into the connector hole from the outside of the case by directing the open end of the cylindrical section into which the insulating housing is inserted toward the case, thereby making the cylindrical section pass through the connector hole, and the cover member is attached in a state in which the brim section of the cover member covers the outer side of the connector hole. At this point, the waterproof connector is in such a state that the insulating housing is inserted into the open end positioned inside the case, and the circular sealing member is interposed between the inner surface of the cylindrical section and the circumference of the insulating housing.

At the time when the circuit board is fixed to the case, once a displacement of the position of the insulating housing with respect to the case takes place due to a displacement of the installation position of the circuit board with respect to the case and a displacement of the installation position of the insulating housing with respect to the circuit board, the cover member is attached to the case in a state in which the insertion position of the insulating housing with respect to the cylindrical section is displaced. With the invention, even in the situation where the insertion position of the insulating housing with respect to the cylindrical section is displaced, the state in which a gap between the insulating housing and the cylindrical section is filled with the circular sealing member is maintained. Therefore, the structure in which the circuit board is fixed to the case is adopted, and no gap that allows liquid or air to enter externally is formed even when the installation position of the circuit board with respect to the case is displaced and the installation position of the insulating housing with respect to the circuit board is displaced. Accordingly, an airtight structure is completed only by fitting the cover member, via the connector hole, into the case to which the insulating housing and the circuit board are fixed, thereby securing the cover member to the case. This structure does not require components such as the relay connector and internal wires like those used in the conventional technique, making it possible to carry out assembly work readily and reliably. In addition, since the components such as internal wires are not required, the number of contact points between components is decreased, thereby improving reliability.

The cylindrical section of the cover member is inserted into the connector hole while leaving a space in the connector hole and also, the screw is inserted into the insertion hole formed in the brim section while leaving a space in the insertion hole. Therefore, even when a displacement of the position of the insulating housing with respect to the case takes place in the direction in which the brim section spreads out, due to a displacement of the installation position of the case with respect to the circuit board and a displacement of the installation position of the circuit board with respect to the insulating housing, the cover member into which the insulating housing is inserted is fixed to the case while being displaced in the direction in which the brim section spreads out. Accordingly, a state in which the connector hole is closed by the brim section is maintained.

With the mounting structure of the present invention, no gap that allows liquid or air to enter externally is formed even in a case where, after the circuit board is fixed to the case, the installation position of the circuit board with respect to the case is displaced and the installation position of the insulating housing with respect to the circuit board is displaced. Further, since there is no need to provide components such as the relay connector and internal wires like those used in the conventional technique, an increase in the number of components and the number of work processes can be prevented.

The present invention also consist in a method of mounting a waterproof connector as set forth in claim 9 hereof.

According to the mounting method of the present invention, an airtight structure is completed only by fitting the cover member, via the connector hole, into the case to which the insulating housing and the circuit board are fixed, thereby securing the cover member to the case. Therefore, the mounting work is easy.

As described above, according to the present invention, there are realized, the mounting structure of the waterproof connector and the mounting method of the waterproof connector, in which a displacement of the position of the waterproof connector with respect to the case is allowed while preventing an increase in the number of components and the number of work processes.

### Brief Description of Drawings

FIG. 1 is an exploded perspective view of a waterproof connector according to an embodiment of the present invention.
FIG. 2 is a cross-sectional diagram of the waterproof connector shown in FIG. 1.
FIG.3 is a cross-sectional diagram of the electronic control unit in which the waterproof connector shown in FIG. 1 and FIG. 2 is implemented.
FIG. 4 is a perspective diagram showing a mounting process and a board fixing process of an assembly method of the electronic control unit shown in FIG. 3.
FIG. 5 is a perspective diagram showing a state in which a circuit board is fixed to a base section of a case by going through the board fixing process and the housing mounting process.
FIG. 6 is a perspective diagram that shows a cover attachment process.
FIG. 7 is a cross-sectional diagram that shows the cover attachment process.
FIG. 8 is a perspective view that shows a cover-member insertion process and a cover-member fixing process.
FIG. 9 is a front view that shows the cover-member insertion process and the cover-member fixing process.
FIG. 10 is a perspective diagram showing a state in which a mating connector is connected to the electronic control unit.
FIG. 11 is a cross-sectional diagram showing the state in which the mating connector is connected to the electronic control unit.
FIG. 12 is a cross-sectional diagram that shows an internal structure of an electronic device according to a conventional technique.
FIG. 13 is a cross-sectional diagram that shows an internal structure of an electronic device according to another conventional technique.

### Best Mode for Carrying out the Invention

An embodiment of the present invention will be described as follows with reference to the drawings.

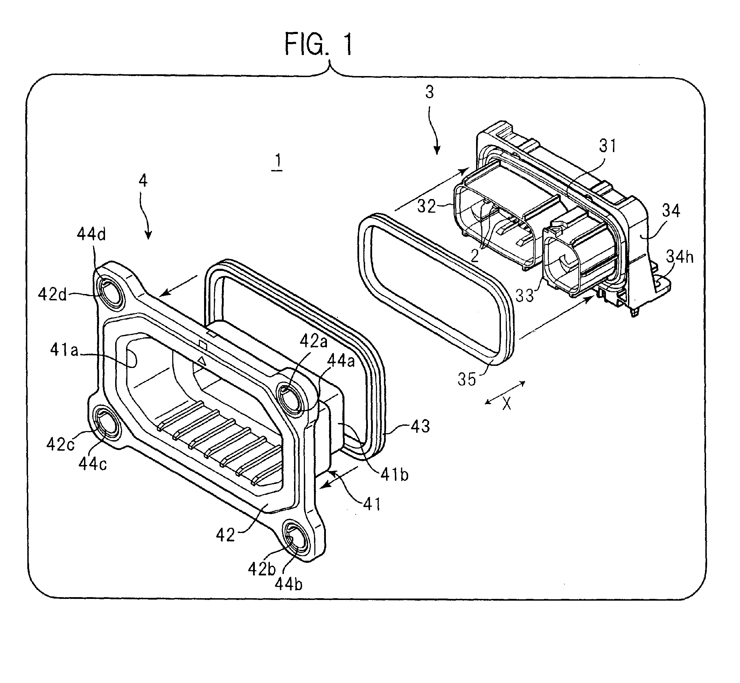

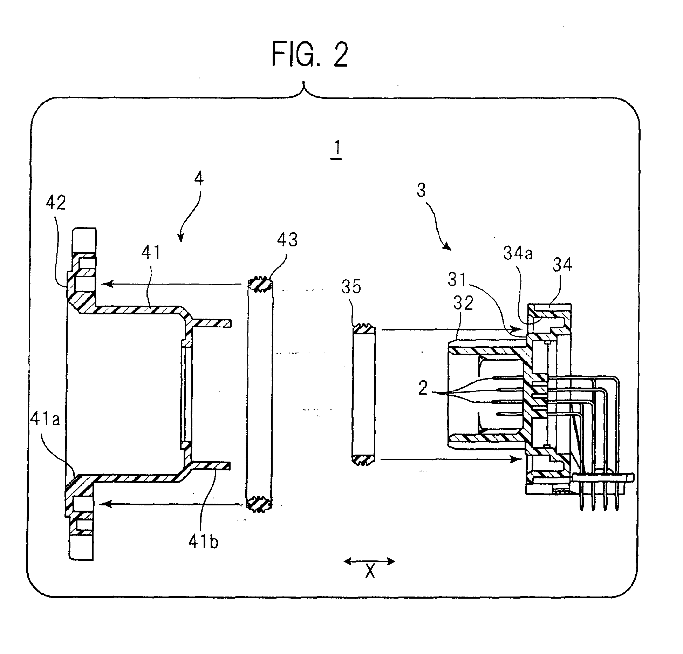

FIG. 1 is an exploded perspective view of a waterproof connector according to an embodiment of the present invention, and FIG. 2 is a cross-sectional diagram of the waterproof connector shown in FIG. 1.

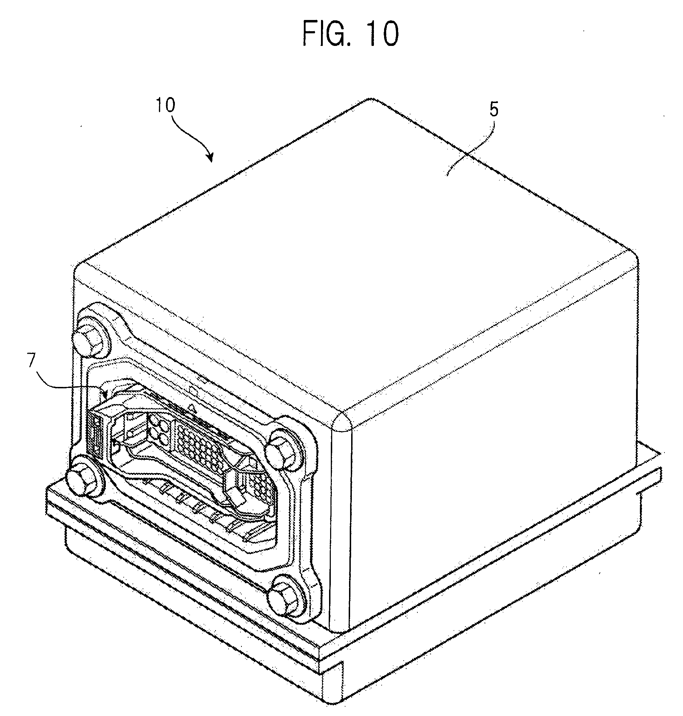

A waterproof connector 1 shown in FIG. 1 and FIG. 2 is a female connector implemented on a circuit board disposed in a case. The waterproof connector 1 includes: contacts 2 for electrical connection; an insulating housing 3 holding the contacts 2 and to be mated with a male connector 7 (see FIG. 10) that is a mating connector; and a cover member 4 to be coupled to the insulating housing 3. In the waterproof connector 1, a direction in which the mating connector is inserted and removed is an insertion/removal direction X.

The insulating housing 3 is a molded article made of an insulating resin material and includes: a housing body section 31 that is substantially tabular and supports the contacts 2; two fitting hood sections 32 and 33 that project from a front surface of the housing body section 31, which surface is to be opposite the mating connector; and a guide hood section 34 linked to and provided behind the housing body section 31, and having a shape that surrounds the circumference of the housing body section 31. The housing body section 31, the fitting hood sections 32 and 33, and the guide hood section 34 are integrally formed. Also, a circular sealing member 35 made of an elastomer is provided on the circumference of the housing body section 31. The sealing member 35 disposed on the circumference of the housing body section 31 is surrounded by the guide hood section 34 with a substantially uniform gap in between. A circular groove 34a is formed between the circumference of the sealing member 35 and the guide hood section 34.

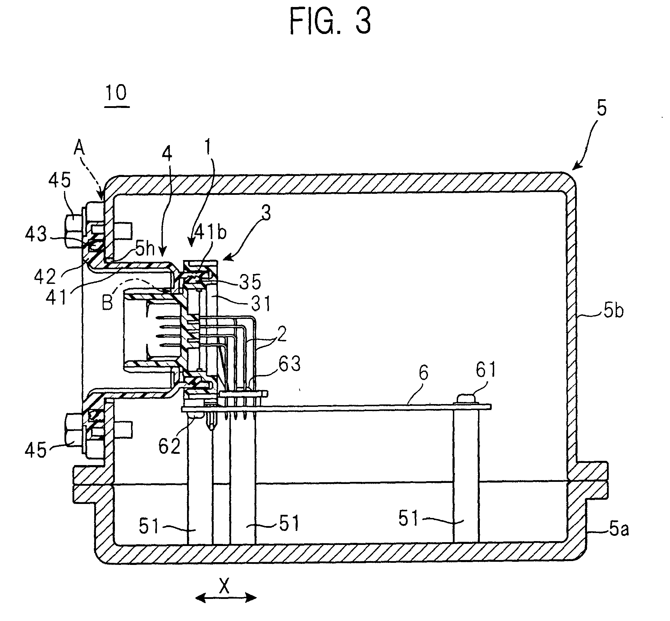

As shown in FIG. 2, the contacts 2 protrude from the front surface of the housing body section 31 along the insertion/removal direction X. The contacts 2 are surrounded by the fitting hood sections 32 and 33 and disposed with a predetermined pitch. The contacts 2 are bent on the rear side of the housing body section 31 and extended thereafter so that the tips of the bent and extended portions of the contacts 2 are connected to the circuit board 6 (see FIG. 3).

At a lower part of the guide hood section 34, there are formed: through holes 34h through which screws for fixing the insulating housing 3 to the circuit board are inserted; and tapped holes (not illustrated).

The cover member 4 is a molded article made of an insulating resin material and includes: a cylindrical section 41 into which the housing body section 31 is inserted; and a brim section 42 formed at one open end 41a of the cylindrical section 41 and spreading outwards. The cylindrical section 41 and the brim section 42 are integrally formed. A circular sealing member 43 made of an elastomer is disposed on the brim section 42 of the cover member 4 to surround the cylindrical section 41.

Of two open ends 41a and 41b, an open end 41b opposite to the open end 41a where the brim section 42 is provided has a shape that conforms to the shape of the circumference of the housing body section 31 included in the insulating housing 3. The inner wall of the open end 41b is formed to be slightly smaller than the circumference of the sealing member 35, so that the sealing member 35 into which the housing body section 31 is inserted comes into intimate contact with the cylindrical section 41 and the housing body section 31. When installed in a case 5 (see FIG. 3), the cylindrical section 41 of the cover member 4 is inserted into a connector opening 5h formed in the case 5 (see FIG. 3). The cylindrical section 41 is formed to be smaller than the connector opening 5h to such a degree that the cylindrical section 41 in a state of being inserted into the connector opening 5h can move in a direction substantially perpendicular to the insertion/removal direction X, namely in the direction in which the brim section 42 spreads out.

The brim section 42 is shaped like a plate with a substantially rectangular circumference and formed to be larger than the connector opening 5h of the case 5. Formed at four corners of the brim section 42 are four openings 42a, 42b, 42c and 42d. Cylindrical reinforcing members 44a 44b, 44c and 44d made of a metallic material are embedded in these openings 42a through 42d, respectively. The reinforcing members 44a through 44d form insertion holes into which bolts 45 (see FIG. 3) are respectively inserted. The diameter of the insertion hole formed by each of the reinforcing members 44a through 44d is larger than the diameter of the bolt 45 to such an extent that the brim section 42, in the state in which the bolt 45 is inserted, can move in the direction in which the brim section 42 spreads.

Subsequently, a mounting structure of the waterproof connector 1 will be described by taking an automotive electronic control unit as an example.

FIG. 3 is a cross-sectional diagram that shows the electronic control unit in which the waterproof connector shown in FIG. 1 and FIG. 2 is implemented.

An electronic control unit 10 shown in FIG. 3 includes the case 5, the circuit board 6 disposed in the case 5, and the waterproof connector 1 mounted on the circuit board 6.

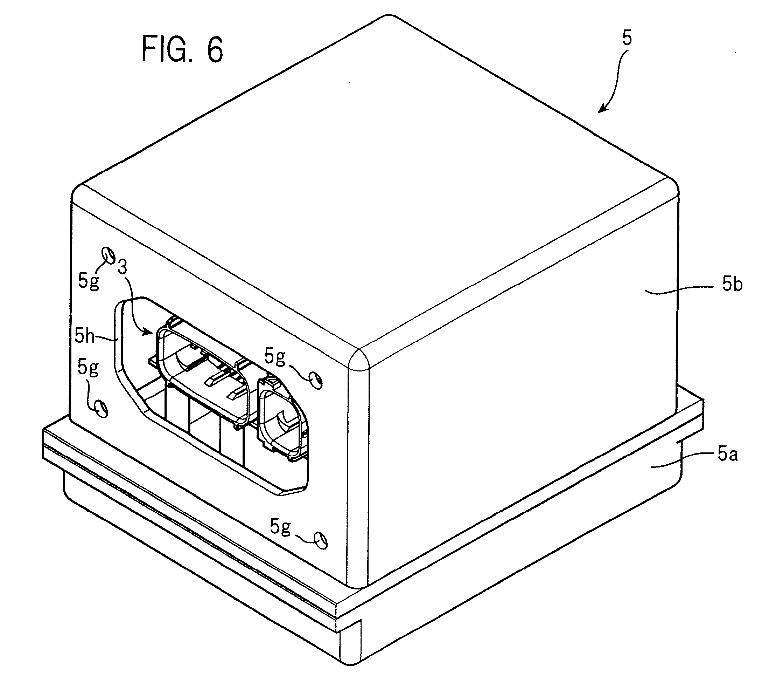

The case 5 includes a base section 5a to which the circuit board 6 is fixed and a cover section 5b. The cover section 5b has: the connector opening 5h for connecting the waterproof connector 1 to the mating connector, and tapped holes 5g (see FIG. 6) into which the bolts 45 for fixing the waterproof connector 1 to the cover section 5b are inserted. When the base section 5a and the cover section 5b are coupled to each other, the case 5 is completed as an integral unit. Incidentally, illustration of a sealing member disposed between the base section 5a and the cover section 5b is omitted. On an inner surface of the base section 5a, pillar-shaped spacers 51 that support two or more circuit boards including the circuit board 6 are provided. The circuit board 6 is fixed within the case 5 by being secured to the spacers 51 with screws 61. Incidentally, the electronic control unit 10 has such a structure in the case 5 that two or more circuit boards are arranged in a vertical direction via the spacers 51, but illustration of the circuit boards except the circuit board 6 is omitted. The waterproof connector 1 is mounted on the circuit board 6 among the two or more circuit boards. The tips of the contacts 2 of the waterproof connector 1 in the state of being inserted into the circuit board 6 are connected to the circuit board 6 by soldering, and the insulating housing 3 also is secured to the circuit board 6 by using screws 62 and 63. The circular sealing member 35 is disposed on the circumference of the housing body section 31 of the insulating housing 3. Incidentally, besides the waterproof connector 1, multiple electronic components required for the operations of the electronic control unit 10 are implemented on the circuit board 6, but illustration of the electronic components except the waterproof connector 1 is omitted.

The cover member 4 of the waterproof connector 1 is fixed to the cover section 5b of the case 5 with the bolts 45. The bolts 45 passing through the cylindrical reinforcing members 44a through 44d (see FIG. 2) provided in the brim section 42 of the cover member 4 are inserted into the tapped holes 5g formed in the cover section 5b. The cylindrical section 41 connecting to the brim section 42 is inserted into the connector opening 5h. The open end 41b of the cylindrical section 41 is to be positioned inside the case 5, and the housing body section 31 of the insulating housing 3 is engaged in the open end 41b with the sealing member 35 interposed in between. The open end 41b of the cylindrical section 41 is closed by the insulating housing 3. The sealing member 35 is in intimate contact with the circumference of the housing body section 31 and the internal circumference of the open end 41b of the cylindrical section 41.

In the electronic control unit 10, a gap A between the waterproof connector 1 and the case 5 is sealed by the sealing member 43 provided in the cover member 4. Also, a gap B between the insulating housing 3 and the cover member 4 is sealed by the sealing member 35 provided in the insulating housing 3. Therefore, the case 5 is made airtight securely.

In the electronic control unit 10, the insulating housing 3 is fixed to the circuit board 6, and the circuit board 6 is fixed to the case 5. The installation position of the circuit board 6 with respect to the case 5 and the installation position of the insulating housing 3 with respect to the circuit board 6 are allowed to be deviated from reference positions within installation tolerances. Because of a displacement in the installation position of the circuit board 6 with respect to the case 5 and a displacement in the installation position of the insulating housing 3 with respect to the circuit board 6, the position of the insulating housing 3 with respect to the case 5 is deviated from a reference position.

Once a displacement of the position of the insulating housing 3 with respect to the case 5 occurs, the position of the housing body section 31 inserted into the cylindrical section 41 of the cover member 4 fixed to the case 5 is deviated in the insertion direction, i.e. the insertion/removal direction X, displacing the cover member 4 with respect to the case 5 in a direction perpendicular to the insertion/removal direction X, i.e. the direction in which the brim section 42 spreads. Even in this situation, the state in which a gap between the insulating housing 3 and the cylindrical section 41 is sealed by the sealing member 35 is maintained. Also, the state in which the connector opening 5h is closed by the brim section 42 is maintained.

Subsequently, a method of mounting the waterproof connector 1 shown in FIG. 1 on the circuit board and assembling the electronic control unit 10 shown in FIG. 3 will be described. The assembly method of the electronic control unit 10 includes a housing mounting process, a board fixing process, a cover attachment process, a cover-member insertion process and a cover-member fixing process.

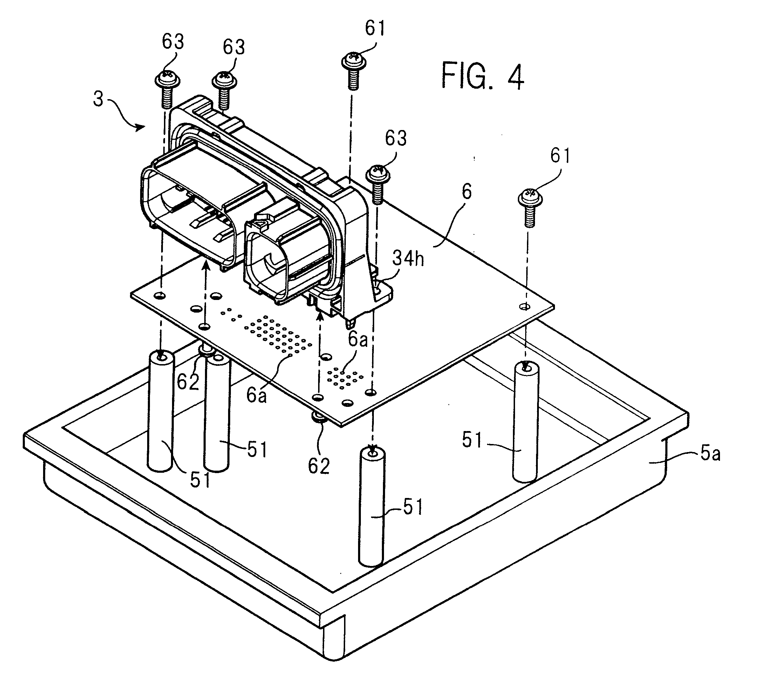

FIG. 4 is a perspective diagram showing the housing mounting process and the board fixing process of the assembly method of the electronic control unit 10. FIG. 4 illustrates the housing mounting process and the board fixing process together to readily view the positional relations between the components.

First, in the housing mounting process, the insulating housing 3 of the waterproof connector 1 is mounted on the circuit board 6. To be more specific, the insulating housing 3 is attached on the circuit board 6 by making the contacts 2 (see FIG. 2) pass through holes 6a of the circuit board 6. Subsequently, the screws 62 are made to pass through the circuit board 6 and inserted into the tapped holes formed on a lower surface of the guide hood section 34 of the insulating housing 3, thereby securing the insulating housing 3 to the circuit board 6.

Subsequently, in the board fixing process, the circuit board 6 to which the insulating housing 3 is fixed in the housing mounting process is secured to the case 5. The circuit board 6 is disposed on the spacers 51 provided on the base section 5a of the case 5 and then, the screws 61 and 63 are inserted into the tips of the spacers 51 after passing through the circuit board 6 and tightened to be fixed. The screws 63 are inserted into the spacers 51 after passing through the through holes 34h formed in the insulating housing 3 and the circuit board 6, so that the fixing of the insulating housing 3 and the circuit board 6 is reinforced.

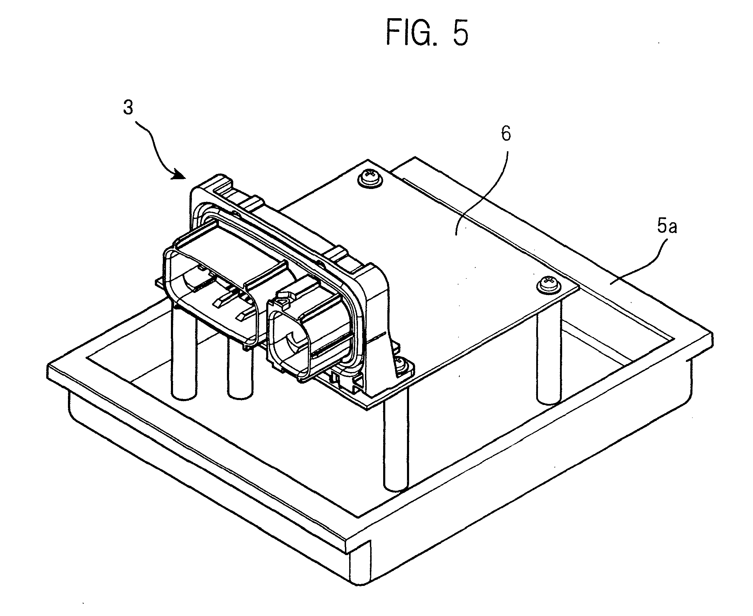

By going through the housing mounting process and board fixing process, the insulating housing 3 is fixed to the circuit board 6 and the circuit board 6 is fixed to the base section 5a of the case 5 as shown in FIG. 5.

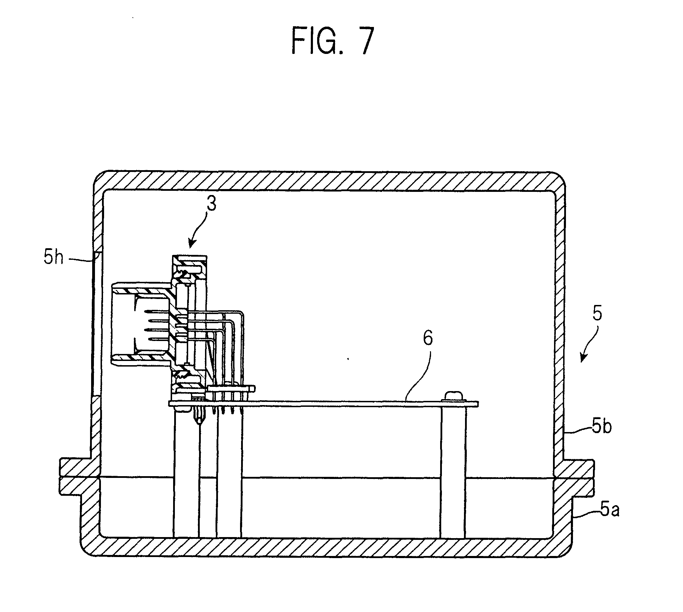

FIG. 6 and FIG. 7 are diagrams that show the cover attachment process. FIG. 6 is a perspective diagram, and FIG. 7 is a cross-sectional diagram.

In the cover attachment process, the cover section 5b is coupled to the base section 5a on which the insulating housing 3 and the circuit board 6 are fixed. The base section 5a and the cover section 5b are tightly connected to each other with no gap in between. The base section 5a and the cover section 5b are coupled to each other with a sealing member (not illustrated) interposed between the base section 5a and the cover section 5b. The base section 5a and the cover section 5b may be fastened to each other with screws and the like, or may be fixed to each other with, for example, an adhesive. When the cover section 5b and the base section 5a are united, the case 5 is completed.

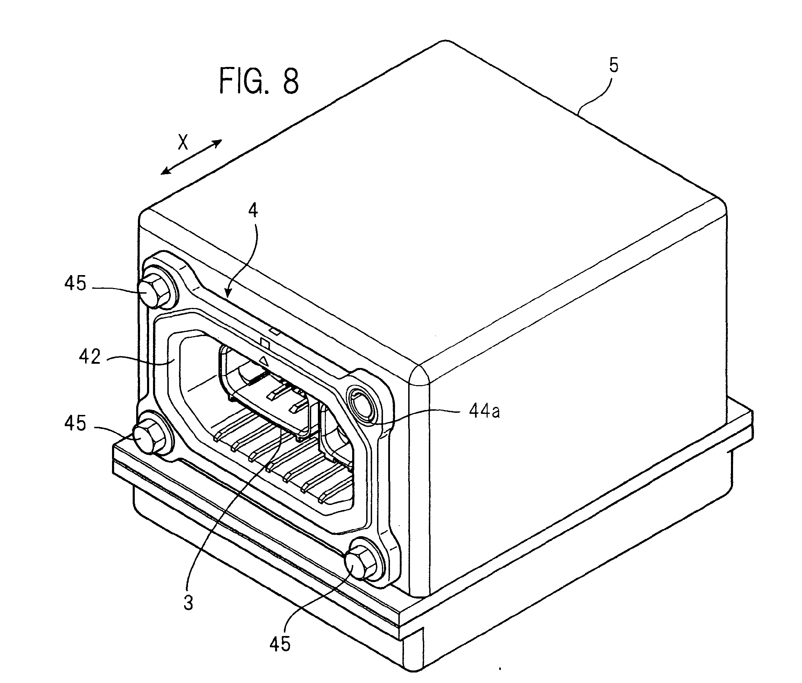

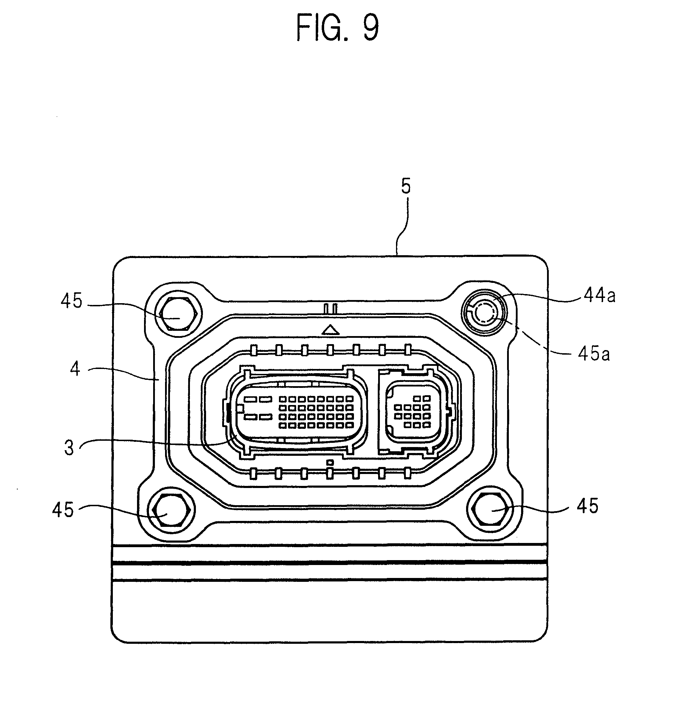

FIG. 8 and FIG. 9 are diagrams which show the cover-member insertion process and the cover-member fixing process. FIG. 8 is a perspective view, and FIG. 9 is a front view.

In the cover-member insertion process, the cover member 4 is attached to the insulating housing 3 and the case 5. To be more specific, the cylindrical section 41 of the cover member 4 with the open end 41b (see FIG. 1) directed toward the inside of the case 5 is inserted into the connector opening 5h (see FIG. 6), and the housing body section 31 (see FIG. 1) of the insulating housing 3 is fitted into the open end 41b. As shown in FIG. 1, the open end 41b of the cylindrical section 41 is guided to the groove 34a formed between the guide hood section 34 and the housing body section 31, and engaged in the insulating housing 3. The cover member 4 is inserted until the brim section 42 abuts the case 5. The brim section 42 is larger than the connector opening 5h, and abuts the case 5 while covering the edge of the connector opening 5h from the outside of the case 5. Corresponding to a displacement of the position of the insulating housing 3, the cover member 4 is attached to the case 5 at a position deviated from a reference position in a direction perpendicular to the insertion/removal direction X.

Subsequently, in the cover-member fixing process, the four bolts are inserted into the insertion holes formed by the respective reinforcing members 44a through 44d of the brim section 42. In this state, the four bolts are inserted into the tapped holes 5g (see FIG. 6) formed in the case 5, and tightened. Incidentally, FIG. 8 and FIG. 9 illustrate a state in which among the four bolts for fixing the cover member, three bolts are already tightened. In FIG. 9, an outer diameter 45a of the thread part of the bolt is indicated with a chain line in an area where the bolt has not yet been inserted. As shown in FIG. 9, the insertion holes formed by the respective reinforcing members 44a through 44d are larger than the outer diameter 45a of the thread part of the bolt. Therefore, the cover member 4 is reliably fixed to the case 5 even when disposed at a position deviated from a reference position. When the fixing by tightening the four bolts 45 is completed, the assembly of the electronic control unit shown in FIG. 3 is finished.

In the assembly of the electronic control unit 10 shown in FIG. 4 through FIG. 9, the cover member 4 is fixed to the case 5 in such a manner that the cover member 4 is pushed from the outside to be fitted via the connector opening 5h into the case 5 to which the insulating housing 3 and the circuit board 6 are secured. Only by fixing the cover member 4 in this manner, a waterproof structure is completed.

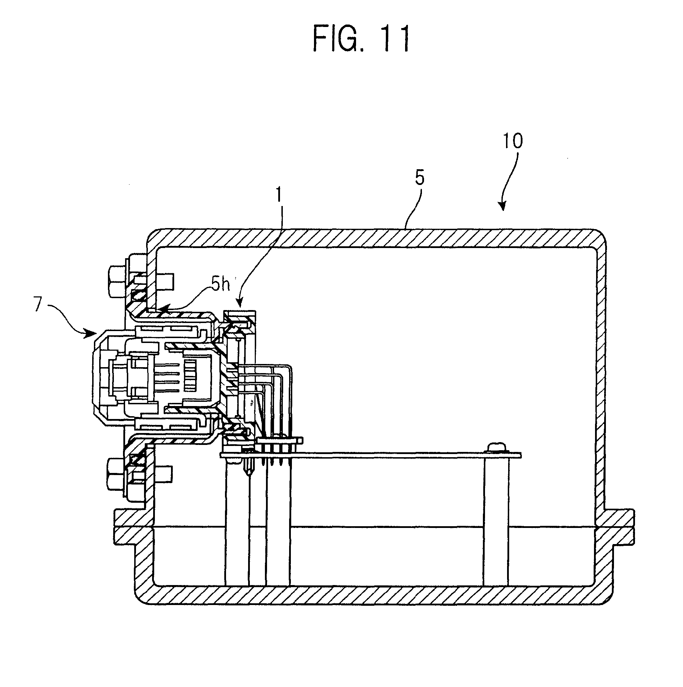

FIG. 10 and FIG. 11 are diagrams showing a state in which the mating connector is connected to the electronic control unit shown in FIG. 3. FIG. 10 is a perspective diagram, and FIG. 11 is a cross-sectional diagram. In FIG. 11, hatching of the mating connector is omitted so that the structure can be readily viewed.

As shown in FIG. 10 and FIG. 11, the mating connector 7 is mated with the waterproof connector 1 provided in the electronic control unit 10 through the connector opening 5h formed in the case 5.

Incidentally, in the above description of the embodiment, it is assumed that the present invention is applied to the automotive electronic control unit. However, the present invention is not limited to the automotive electronic control unit and may be applied to various types of electronic device required to be waterproofed.

Further, in the above description of the embodiment, there is employed the example in which the insulating housing 3 has the guide hood section 34. However, the present invention is not limited to this example and may have, for example, a structure in which the insulating housing has no guide hood section.

Furthermore, the assembly method of the electronic control unit of the embodiment has been described by using the example in which the housing mounting process, the board fixing process, the cover attachment process, the cover-member insertion process and the cover-member fixing process are sequentially carried out. However, the present invention is not limited to this example and, for example, the housing mounting process may be executed after the board fixing process.

## Claims

1. A mounting structure of a waterproof connector (1) mounted on a circuit board (6) fixed in a case (5), and connectable to a mating connector (7) via a connector hole (5h) formed in the case, wherein:
the waterproof connector (1) comprises:
a contact (2) connected to the circuit board (6) and for establishing electrical connection with the mating connector (7);
an insulating housing (3) that holds the contact and has a circular sealing member (35) on a circumference thereof;
a cover member (4) that includes a cylindrical section (41) having two open ends (41a,41b), into one (41b) of which the insulating housing (3) is inserted with the sealing member (35) interposed between the one end (41b) and the insulating housing, the other open end (41a) being positioned outside the case (5), and a brim section (42) spreading outwards to be broader than the connector hole (5h) and covering an edge of the connector hole from the outside of the case,
said cylindrical section (41) having an outer shape smaller than the connector hole (5h) to such an extent that the position of the cover member is displaceable in a direction in which the brim section (42) spreads, and
a sealing member (43) provided between the case (5) and the brim section (42) of the cover member,
**characterized in that** the cylindrical section (41) of the cover member (4) passes through the connector hole (5h), has its one open end (41b) positioned inside the case (5), the brim section (42) formed at its other end (41a), and further **characterised in that** the brim section (42) has an insertion hole (42a - 42d) into which a screw (45) for fixing the cover member to the case is inserted and which has a diameter larger than a diameter of the screw (45) to such an extent that the position of the cover member (4) in a state in which the screw is inserted into the insertion hole is displaceable in the direction in which the brim section spreads.

2. The mounting structure according to claim 1, wherein the insulating housing is a molded article made from a resin material.

3. The mounting structure according to claim 1 or 2, wherein the insulating housing comprises a housing body section (31) which is substantially tubular and supports the contact.

4. The mounting structure according to claim 3, wherein the insulating housing comprises a fitting hood section (33) projecting from a front surface of the housing body section (31).

5. The mounting structure according to claim 3 or 4, wherein the insulating housing comprises a guide hood section (34) linked to and located behind the housing body section (31).

6. The mounting structure according to claim 5, comprising a circular groove (34a) formed between the circumference of the circular seating member (35) and the guide hood section (34).

7. The mounting structure according to any preceding claim, comprising a cylindrical reinforcing member (44a-44d) disposed in and forming the insertion hole through which the screw (45) may be inserted.

8. The waterproof connector according to claim 7, wherein the contact (2) protrudes from the front surface of the housing body section (31) and is surrounded by the fitting hood section (33).

9. A method of mounting a waterproof connector together with a circuit board (6) in a case (5) comprising a base section (5a), a cover section (5b) and a connector hole (5h), the waterproof connector having a mounting structure according to any preceding claim, **characterized by**:
fixing the circuit board (6) to the base section (5a);
fixing the insulating housing (3) to the circuit board;
coupling the cover section (5b) to the base section (5a);
inserting the cover member (4) into the connector hole (5h) by directing the one open end (41b) into which the insulating housing is inserted toward the inside of the case (5), fitting the insulating housing (3) into the one open end (41b), and covering an edge of the connector hole (5h) with the brim section (42) from the outside of the case; and
fixing the brim section (42) to the case (5).

## Patentansprüche

1. Montagestruktur für einen wasserdichten Steckverbinder (1), der auf einer Leiterplatte (6) montiert ist, die in einem Gehäuse (5) befestigt ist, und der mit einem Gegensteckverbinder (7) über ein Verbinderloch (5h) verbunden werden kann, das im Gehäuse ausgebildet ist, wobei:
der wasserdichte Steckverbinder (1) aufweist:
einen Kontakt (2), der mit der Leiterplatte (6) verbunden ist, für das Einrichten einer elektrischen Verbindung mit dem Gegensteckverbinder (7);
ein Isolationsgehäuse (3), das den Kontakt aufnimmt und ein kreisförmiges Dichtungselement (35) auf einem Umfang davon aufweist;
ein Abdeckelement (4), das umfasst: einen zylindrischen Abschnitt (41) mit zwei offenen Enden (41a, 41b), wobei in eines (41b) davon das Isolationsgehäuse (3) eingesetzt wird, wobei das Dichtungselement (35) zwischen dem einen Ende (41b) und dem Isolationsgehäuse angeordnet wird, wobei das andere offene Ende (41a) außerhalb des Gehäuses (5) positioniert wird; und einen Randabschnitt (42), der sich nach außen ausbreitet, damit er breiter ist als das Verbinderloch (5h) und einen Rand des Verbinderloches von außerhalb des Gehäuses bedeckt,
wobei der zylindrische Abschnitt (41) eine äußere Form aufweist, die kleiner ist als das Verbinderloch (5h) in einem derartigen Maß, dass die Position des Abdeckelementes in einer Richtung verschiebbar ist, in der sich der Randabschnitt (42) ausbreitet; und
ein Dichtungselement (43), das zwischen dem Gehäuse (5) und dem Randabschnitt (42) des Abdeckelementes bereitgestellt wird,
**dadurch gekennzeichnet, dass** der zylindrische Abschnitt (41) des Abdeckelementes (4) durch das Verbinderloch (5h) gelangt, wobei sein eines offenes Ende (41b) innerhalb des Gehäuses (5) positioniert ist, wobei der Randabschnitt (42) an seinem anderen Ende (41a) ausgebildet ist, und außerdem **dadurch gekennzeichnet, dass** der Randabschnitt (42) ein Einsetzloch (42a-42d) aufweist, in das eine Schraube (45) für das Befestigen des Abdeckelementes am Gehäuse eingesetzt wird, und das einen Durchmesser aufweist, der in einem derartigen Maß größer ist als ein Durchmesser der Schraube (45), dass die Position des Abdeckelementes (4) in einem Zustand, in dem die Schraube in das Einsetzloch eingesetzt wird, in der Richtung verschiebbar ist, in der sich der Randabschnitt ausbreitet.

2. Montagestruktur nach Anspruch 1, bei der das Isolationsgehäuse ein aus einem Harzmaterial hergestellter Formkörper ist.

3. Montagestruktur nach Anspruch 1 oder 2, bei der das Isolationsgehäuse einen Gehäusekörperabschnitt (31) aufweist, der im Wesentlichen rohrförmig ist und den Kontakt trägt.

4. Montagestruktur nach Anspruch 3, bei der das Isolationsgehäuse einen passenden Kappenabschnitt (33) aufweist, der aus einer Vorderfläche des Gehäusekörperabschnittes (31) vorsteht.

5. Montagestruktur nach Anspruch 3 oder 4, bei der das Isolationsgehäuse einen Führungskappenabschnitt (34) aufweist, der mit dem Gehäusekörperabschnitt (31) verbunden und dahinter angeordnet ist.

6. Montagestruktur nach Anspruch 5, die eine kreisförmige Nut (34a) aufweist, die zwischen dem Umfang des kreisförmigen Dichtungselementes (35) und dem Führungskappenabschnitt (34) ausgebildet ist.

7. Montagestruktur nach einem der vorhergehenden Ansprüche, die ein zylindrisches Verstärkungselement (44a-44d) aufweist, das im Einsetzloch angeordnet ist und dieses bildet, durch das die Schraube (45) eingesetzt werden kann.

8. Wasserdichter Steckverbinder nach Anspruch 7, bei dem der Kontakt (2) aus der Vorderfläche des Gehäusekörperabschnittes (31) vorsteht und vom passenden Kappenabschnitt (33) umgeben wird.

9. Verfahren zum Montieren eines wasserdichten Steckverbinders zusammen mit einer Leiterplatte (6) in einem Gehäuse (5), das einen Basisabschnitt (5a), einen Abdeckabschnitt (5b) und ein Verbinderloch (5h) aufweist, wobei der wasserdichte Steckverbinder eine Montagestruktur nach einem der vorhergehenden Ansprüche aufweist, **gekennzeichnet durch** die folgenden Schritte:
Befestigen der Leiterplatte (6) am Basisabschnitt (5a);
Befestigen des Isolationsgehäuses (3) an der Leiterplatte;
Verbinden des Abdeckabschnittes (5b) mit dem Basisabschnitt (5a);
Einsetzen des Abdeckelementes (4) in das Verbinderloch (5h), indem das eine offene Ende (41b), in das das Isolationsgehäuse eingesetzt wird, in Richtung der Innenseite des Gehäuses (5) gerichtet wird, wobei das Isolationsgehäuse (3) in das eine offene Ende (41b) eingepasst wird, und wobei ein Rand des Verbinderloches (5h) mit dem Randabschnitt (42) von außerhalb des Gehäuses bedeckt wird; und
Befestigen des Randabschnittes (42) am Gehäuse (5).

## Revendications

1. Structure de montage pour un connecteur étanche à l'eau (1), monté sur une carte de circuit imprimé (6) fixée dans un logement (5), et pouvant être connecté à un connecteur d'accouplement (7) par l'intermédiaire d'un trou de connecteur (5h) formé dans le logement, dans laquelle :
le connecteur étanche à l'eau (1) comprend :
un contact (2), connecté à la carte de circuit imprimé (6) et destiné à établir une connexion électrique avec le connecteur d'accouplement (7) ;
un boîtier isolant (3), retenant le contact et comportant un élément d'étanchéité circulaire (35) sur sa circonférence ;
un élément de couverture (4), englobant une section cylindrique (41) comportant deux extrémités ouvertes (41a, 41b), dans l'une desquelles (41b) est inséré le boîtier isolant (3), l'élément d'étanchéité (35) étant agencé entre ladite une extrémité (41b) et le boîtier isolant, l'autre extrémité ouverte (41a) étant positionnée hors du logement (5), et une section de bordure (42) s'étendant vers l'extérieur de sorte à être plus large que le trou de connecteur (5h) et recouvrant un bord du trou de connecteur à partir de l'extérieur du logement ;
ladite section cylindrique (41) ayant une forme externe plus petite que le trou de connecteur (5h), de sorte que la position de l'élément de couverture peut être déplacée dans une direction dans laquelle s'étend la section de bordure (42) ; et
un élément d'étanchéité (43), agencé entre le logement (5) et la section de bordure (42) de l'élément de couverture ;
**caractérisée en ce que** la section cylindrique (41) de l'élément de couverture (4) passe à travers le trou de connecteur (5h), son extrémité ouverte (41b) étant positionnée à l'intérieur du logement (5), la section de bordure (42) étant formée au niveau de son autre extrémité (41a), et **caractérisée en outre en ce que** la section de bordure (42) comporte un trou d'insertion (42a-42d), dans lequel est insérée une vis (45) pour fixer l'élément de couverture sur le logement, et ayant un diamètre supérieur à un diamètre de la vis (45), de sorte que la position de l'élément de couverture (4), dans un état dans lequel la vis est insérée dans le trou d'insertion, peut être déplacée dans la direction d'extension de la section de bordure.

2. Structure de montage selon la revendication 1, dans laquelle le boîtier isolant est un article moulé composé d'un matériau de résine.

3. Structure de montage selon les revendications 1 ou 2, dans laquelle le boîtier isolant comprend une section de corps du boîtier (31), ayant une forme pratiquement tubulaire et supportant le contact.

4. Structure de montage selon la revendication 3, dans laquelle le boîtier isolant comprend une section de capot d'ajustement (33) débordant d'une surface avant de la section de corps du boîtier (31).

5. Structure de montage selon les revendications 3 ou 4, dans laquelle le boîtier isolant comprend une section de capot de guidage (34) reliée à la section de corps du boîtier (31) et agencée derrière celle-ci.

6. Structure de montage selon la revendication 5, comprenant une rainure circulaire (34a) formée entre la circonférence de l'élément d'étanchéité circulaire (35) et la section du capot de guidage (34).

7. Structure de montage selon l'une quelconque des revendications précédentes, comprenant un élément de renforcement cylindrique (44a-44d), agencé dans le trou d'insertion, à travers lequel la vis (45) peut être insérée, et formant celui-ci.

8. Connecteur étanche à l'eau selon la revendication 7, dans lequel le contact (2) déborde de la surface avant de la section de corps du boîtier (31) et est entouré par la section du capot d'ajustement (33).

9. Procédé de montage d'un connecteur étanche à l'eau, ensemble avec une carte de circuit imprimé (6) dans un logement (5), comprenant une section de base (5a), une section de couverture (5b) et un trou de connecteur (5h), le connecteur étanche à l'eau comportant une structure de montage selon l'une quelconque des revendications précédentes, **caractérisé par** les étapes ci-dessous :
fixation de la carte de circuit imprimé (6) sur la section de base (5a) ;
fixation du boîtier isolant (3) sur la carte de circuit imprimé ;
accouplement de la section de couverture (5b) à la section de base (5a) ;
insertion de l'élément de couverture (4) dans le trou de connecteur (5h) en dirigeant ladite une extrémité ouverte (41b), dans laquelle est inséré le boîtier isolant, vers l'intérieur du logement (5), ajustement du boîtier isolant (3) dans ladite une extrémité ouverte (41b) et recouvrement d'un bord du trou de connecteur (5h) par la section de bordure (42) à partir de l'extérieur du logement ; et
fixation de la section de bordure (42) sur le logement (5).
